# EUROPEAN PATENT SPECIFICATION

(11) **EP 1 526 163 B1**
(45) Date of publication and mention of the grant of the patent: **08.08.2007**
(21) Application number: 04256264.5
(22) Date of filing: 09.10.2004
(51) Int. Cl.: C09G 1/02, C09K 3/14, H01L 21/321, B24B 37/04

(54) **Method of second step polishing in copper CMP with a polishing fluid containing no oxidizing agent**
CMP-Verfahren zur Durchführung des zweiten Polierschrittes bei Kupferlagen mit Oxidationsmittel-freier Polierflüssigkeit
Procédé de seconde étape de polissage CMP pour couches en cuivre avec liquide de polissage sans composant oxydant

(30) Priority: 22.10.2003 US 692093
(43) Date of publication of application: 27.04.2005
(73) Proprietor: Rohm and Haas Electronic Materials CMP Holdings, Inc., Newark, DE 19713 (US)
(72) Inventor: Bian, Jinru, Newark, DE 19713 (US)
(74) Representative: Buckley, Guy Julian

(56) References cited:
- WO-A-01/12739
- US-A1- 2002 017 064
- US-B1- 6 436 829

## Description

### TECHNICAL FIELD

The invention relates, in general, to chemical-mechanical-planarization (CMP) and, more particularly, to polishing fluids for second polishing step by CMP to remove a barrier film on a semiconductor wafer.

### BACKGROUND

Circuit interconnects for semiconductor devices can be formed in a dielectric layer in which multiple trenches are arranged. The interconnects are formed by applying a barrier film over an underlying dielectric layer, followed by applying a metal layer over the barrier film. The metal layer is formed to a sufficient thickness to fill the trenches with metal. The interconnect fabrication process includes the use of a two-step CMP process.

CMP refers to a process of polishing a semiconductor wafer with a polishing pad and a polishing fluid. In a first polishing step, the metal layer is removed from the underlying barrier film and from the underlying dielectric layer. The metal layer is removed, both by abrasion applied by the polishing pad, and by chemical reaction with the polishing fluid accompanied by dissolution of the products of chemical reaction. The first polishing step removes the metal layer, leaving a smooth planar polished surface on the wafer, and further leaving metal in the trenches to provide circuit interconnects that are substantially planar with the polished surface.

A typical first step polishing process includes an aqueous solution having an oxidizing reagent, such as KNO₃ or H₂O₂ in a polishing fluid having pH at acidic regime. The copper metal layer is removed by oxidation of the metal layer by the oxidizer and by abrasion of the polishing pad. Further, the polishing pad abrades the metal layer to minimize redeposition of the dissolved oxides from the solution onto the surface of the material being polished. The copper is removed from an underlying barrier film, for example, of tantalum (Ta) or tantalum nitride (TaN). The barrier film is more resistant to abrasion than is the copper, such that the barrier film acts as a polish stop for stopping the first step polishing of copper. Further, oxidation of the surface of the barrier film by the polishing fluid will inhibit its removal during first step polishing.

In a second polishing step, the barrier film is removed from the underlying dielectric layer. Second step polishing can provide a smooth, planar polished surface on the dielectric layer. Ideally, the second polishing step does not remove the metal in the trenches. Excess metal removal in the second step can add additional dishing to that from the first step.

Dishing is a term that describes the formation of unwanted cavities in the circuit interconnects caused by removing excess metal in the trenches. Dishing can occur in both the first polishing step and in the second polishing step. The circuit interconnects are required to have precise dimensions that determine the electrical impedance of signal transmission lines, as provided by the circuit interconnects. Dishing in excess of acceptable levels causes dimensional defects in the circuit interconnects, which can contribute to attenuation of electrical signals transmitted by the circuit interconnects. A conventional polishing slurry requires too much polishing time for completely removing the barrier metal film on the insulating film because of a considerably lower polishing rate for the barrier metal film. If the polishing rate for the copper film in the trench is equal or higher than that for the barrier metal film, the copper film metal in the trench is excessively polished, resulting in dishing.

The second polishing step should cause minimal erosion. Erosion is a term that describes the unwanted lowering of the surface of the dielectric layer caused by removing some of the dielectric layer underlying the barrier film in a dense interconnect area. This dielectric layer removal is greater than that in a sparse area such as an isolated interconnect area so that the surface of the dense interconnect area becomes depressed in relation to the other surfaces. Erosion that occurs adjacent to the metal in the trenches causes dimensional defects in the circuit interconnects, which can contribute to attenuation of electrical signals transmitted by the circuit interconnects. To minimize erosion, a polishing fluid for second step polishing is desired to remove the barrier film with a higher removal rate than the removal rate for the dielectric layer.

The second polishing step should have a high removal selectivity for the barrier layer relative to the underlying layers. Removal selectivity is defined as a ratio of the removal rate of the barrier film, relative to the removal rate of the comparison layer, for example a dielectric layer or a metal film. Thus, removal selectivity is a measure of the removal of the barrier film relative to the dielectric layer or the metal film. A high removal selectivity is desired. Polishing with a polishing fluid that exhibits high removal selectivity relative to the dielectric layer maximizes removal of the barrier film instead of the dielectric layer.

US Patent 6,547,843 discloses a polishing composition for use in the preparation of a metal wiring layer, comprising water, abrasive grains, an organic acid, and an oxidizing agent, and having a pH of 5.5-10.0 adjusted by an alkaline substance. Since the composition includes an oxidizer, the removal rate of tantalum is from 400 to 870 Å/min while the removal rate of copper is from 360 to 600 Å/min, and the selectivity of Ta/Cu is close to 1.

There is a problem with polishing fluids containing an oxidizing agent in that an oxidizing agent promotes the corrosion of the metal layer and, therefore, promotes dishing of the metal layer. It would be advantageous to find a suitable second step polishing fluid which does not contain an oxidizing agent. It would also be advantageous for a second step polishing fluid to also have a low concentration of abrasive particles. High concentrations of abrasive particles will indeed remove the barrier Ta or TaN at high rates, but may cause other problems, such as causing erosion of the dielectric layer and causing defects in the polished wafer surface.

WO 0112739 discloses an oxidizer-free polishing precursor that is mixed with an oxidizer at the point of use.

### STATEMENT OF INVENTION

A method for removal of a barrier film on a semiconductor wafer by polishing with a polishing pad and a polishing fluid, the polishing fluid comprising abrasive particles in the range of 0.1% to 5% by weight and an organic acid or mixture thereof in the range of 0.5-10% by weight in an aqueous solution at basic pH with no addition of an oxidizing agent. The polishing fluid of this invention contains no oxidizing agent. Surprisingly, the organic acid without the oxidizing agent normally used in CMP polishing fluids and at low polishing abrasive concentrations, provides enhanced barrier removal so that selectivities of both barrier to metal and barrier to dielectric layer are high. Optionally, other components normally used in CMP slurries may be added, such as a copper corrosion inhibitor to further protect the metal copper surface in the trenches. A slurry stabilizer may also be optionally added to the polishing fluids of this invention.

### DETAILED DESCRIPTION

The abrasive particles used in the polishing fluids of this invention may be any of the usual abrasives found in CMP slurries, such as alumina, silica, ceria, zirconia, and the like. Preferred are abrasives consisting of silicon dioxide; for example, fumed silica and colloidal silica.

An average diameter of the silica polishing grain is preferably from 5 nm to 500 nm, more preferably around 50 nm. The content of the silica polishing grain in the polishing slurry may be appropriately selected within the range of 0.1 to 5 wt % in the total amount of the polishing fluid composition in the light of factors such as a polishing efficiency, polishing accuracy, and selectivity of TaN/Cu and TaN/TEOS. It is preferably at least 1 wt % abrasive.

The organic acid used in the polishing slurry of this invention may be at least one selected from the group consisting of organic acids, carboxylic acids, and hydrocarboxylic acids containing a hydroxyl group and a carboxyl group, and amino acids containing amino groups. For example, the following substances may be used: organic acids, such as citric acid, maleic acid, formic acid, acetic acid, propionic acid, butyric acid, valeric acid, acrylic acid, lactic acid, succinic acid, malic acid, malonic acid, tartaric acid, phthalic acid, fumaric acid, lactic acid (alpha-hydroxypropionic acid or beta-hydroxypropionic acid), pimelic acid, adipic acid, glutaric acid, oxalic acid, salicylic acid, glycolic acid, tricarboxylic acid, benzoic acid, and salts of these acids. The amino acid that may be used includes alpha-amino acids and beta-amino acids. An amino acid may be added as a free form, as a salt or as a hydrate. Examples of those which may be added include glutamic acid, glutamic acid hydrochloride, sodium glutaminate monohydrate, glutamine, glutathione, glycylglycine, alanine, beta-alanine, gamma -aminobutyric acid, epsilon-aminocarproic acid, lysine, lysine hydrochloride, lysine dihydrochloride, lysine picrate, histidine, histidine hydrochloride, histidine dihydrochloride, aspartic acid, aspartic acid monohydrate, potassium aspartate, potassium aspartate trihydrate, tryptophan, threonine, glycine, cystine, cysteine, cysteine hydrochloride monohydrate, oxyproline, isoleucine, leucine, methionine, ornithine hydrochloride, phenylalanine, phenylglycine, proline, serine, tyrosine, valine, and a mixture of these amino acids. The salts of these organic acids have an effect to increase solubility and therefore, are used accordingly. These chemicals may be used individually or in combinations of two or more. The content of the above organic acid used in this invention must be at least 0.1 wt % and up to 10%, preferably from 1-5%, most preferable 2-4%, in order to improve the polishing rate of barrier films containing tantalum. When combining two or more organic acids, the above content means their total.

The pH of the polishing fluid of this invention is preferably from 7 to 12, more preferably from pH 8-10 and most preferably around pH 9. The bases used to adjust pH of a slurry of this invention may be a base containing ammonium ion, such as ammonium hydroxide, bases containing alkyl-substituted ammonium ions, bases containing alkali metal ion, bases containing alkali-earth metal ion, bases containing group IIIB metal ion, bases containing group IVB metal ion, bases containing group VB metal ion and salts containing transition metal ion. The designed pH in the basic range is not only for removal of the barrier surface, but is also good for the stability of the slurry of this invention. For the polishing slurry, pH may be adjusted by a known technique. For example, an alkali may be directly added to a slurry in which a silica abrasive is dispersed and an organic acid is dissolved. Alternatively, a part or all of an alkali to be added may be added as an organic alkali salt. Examples of an alkali, which may be used, include alkali metal hydroxides such as potassium hydroxide; alkali metal carbonates such as potassium carbonate; ammonia; and amines as mentioned in this paragraph.

A corrosion inhibitor for the conductive metal, such as copper, may be further added. Addition of an inhibitor may allow a polishing rate for a conductive metal film to be further adjusted and may result in forming a coating film over the surface of the conductive metal film to prevent dishing and corrosion during and after polishing. Examples of the inhibitors include benzotriazole, 1,2,4-triazole, benzofuroxan, 2,1,3-benzothiazole, o-phenylenediamine, m-phenylenediamine, cathechol, o-aminophenol, 2-mercaptobenzimidazole, 2-mercaptobenzoxazole, melamine, and their derivatives. Among these, benzotriazole and its derivatives are preferable. Furthermore, naphthalenetriazole and naphthalenebistriazole as well as substituted naphthalenetriazoles and substituted naphthalenebistriazoles substituted as described above may be used. The content of the inhibitor is preferably at least 0.001 wt %, of the total amount of the polishing slurry for achieving adequate effects of its addition. A polishing slurry of this invention may contain a variety of additives such as dispersing agents, biocide, buffers and viscosity modifiers commonly added to a polishing slurry as long as such additions do not deteriorate the properties of the slurry. The balance of the polishing slurry is water, preferably deionized water.

Experiments were conducted to test variations in the composition of a polishing fluid for second step polishing by CMP to remove a barrier film of TaN from an underlying dielectric layer of silica on a semiconductor wafer. Further, the same Experiments were conducted to remove copper metal from a semiconductor wafer, wherein, the copper metal simulated metal in trenches in a semiconductor wafer. With reference to Table 1, experiments were performed by polishing a barrier film of TaN and a dielectric layer of silica, using a polishing pad and a polishing fluid of basic pH, (pH=9). The pH=9 is a nominal value, as all concentrations of constituents in the polishing fluid are nominal values. Accordingly, all stated measurements of the constituents, as well as the pH measurement, are variable, respectively, about their stated nominal values. Also with reference to Table 1, Tests A and B use polishing fluids containg 0% abrasive and 0% citric acid as reference experiments, wherein 0.002 weight% or 0.1 wt% BTA was added respectively; Test C uses a polishing fluid containing 1 % submicron silicon dioxide abrasive and 0% citric acid as a comparative experiment for testing performances of citric acid; the slurries of Tests 1 through 4 contain 1% silicon dioxide abrasive and increasing concentration of citric acid from 0.5% to 4%. The polishing fluids listed in Table 1 may also comprise a small amount of a biocide. Using these polishing fluids, CMP was conducted on a polishing pad, IC1010 from Rodel Inc, polishing sheet blank wafers. For each polishing fluid, two TaN wafers, two copper wafers and two TEOS wafers were used. The reported removal rates in the table are an average of two wafers.

Comparison of Test B and Test C shows that with 1% abrasive, both TaN and copper removal rate increase from almost zero to 178 Å/min, where both tests contain no organic acid. Tests 1 through 4 show that with continual increase of citric acid concentration in the fluid, the removal rate of tantalum nitride (TaN) increases up to 1350 Å/min, while the copper removal rate is almost constant. The copper removal rates from Test 1 through 4 are close to the copper removal rate of Test C. This indicates that the copper removal is due to the 1% abrasive. The tests show that the organic acid, exampled by citric acid, specifically interacts and removes the barrier (TaN) surface, but not the metal copper surface in the absence of an oxidizer. Further, the tests show that the removal rate of silicon dioxide TEOS is also very low.

Tests D and 5 through 9 have a similar test setup to the Tests 1 through 4. Test D shows that in the presence of 1% silicon dioxide abrasive, but without glutamic acid in the fluid, the TaN removal rate is 20 Å/min, an unacceptable value for barrier removal polishing. The copper removal rate in the test is 178 Å/min, which is the same as in Test C. When 1 or 2 or 4 weight% glutamic acid is added, the TaN removal rate increases up to 1580 Å/min, which indicates that the removal of TaN in these slurry is due to the addition of the amino acid, glutamic acid. The removal rate of copper with the addition of glutamic acid is again almost a constant as in the tests with addition of citric acid. Further, the TEOS removal rate is around 50 Å/min, which is low enough to have a low to zero erosion in pattern wafer polishing. Test 5 shows that without the abrasive, the acid alone will not provide a high TaN removal rate. Therefore, an abrasive is necessary with this amino acid. This also indicates that the removal with glutamic acid is not an etching process but a real CMP process, since the removal of TaN in the test needs a combination of chemical (from glutamic acid) and mechanical (the abrasive) polishing. In the presence of amino acid, increase in silicon dioxide abrasive increases the removal rate of TaN as shown in Tests 7 and 9.

**Table 1**

| Polishing Results and Selectivity | | | | | | | | | | |
|---|---|---|---|---|---|---|---|---|---|---|
| | **Slurry Compositions** | | | | | **Removal Rates** | | | **Selectivity** | |
| Test | 30H50 Solids | BTA % | Citric acid% | pH | biocide % | TaN | Cu | TEOS | TaN Cu | / TaN / TEOS |
| Test A | 0 | 0.002 | 0 | 10 | 0.01 | 4 | | 22.0 | | 0.2 |
| Test B | 0 | 0.1 | 0 | 9 | 0.01 | 6 | 3 | 38.0 | 2.0 | 0.2 |
| Test C | 1 | 0.1 | 0 | 9 | 0.01 | 178 | 178 | 13.0 | 1.0 | 13.7 |
| Test 1 | 1 | 0.1 | 0.5 | 9 | 0.01 | 422 | 152 | 52.0 | 2.8 | 8.1 |
| Test 2 | 1 | 0.1 | 1 | 9 | 0.01 | 1068 | 172 | 76.0 | 6.2 | 14.1 |
| Test 3 | 1 | 0.1 | 2 | 9 | 0.01 | 1025 | 185 | 78.0 | 5.5 | 13.1 |
| Test 4 | 1 | 0.1 | 4 | 9 | 0.01 | 1350 | 150 | 55.0 | 9.0 | 24.5 |

| | **Slurry Compositions** | | | | | **Removal Rates** | | | **Selectivity** | |
|---|---|---|---|---|---|---|---|---|---|---|
| Test | 30H50 Solids | BTA % | glutamic acid% | pH | biocide % | TaN | Cu | TEOS | TaN Cu | / TaN / TEOS |
| Test D | 1 | 0.1 | 0 | 9.00 | 0.01 | 20 | 178 | 13 | 0 | 2 |
| Test 5 | 0 | 0.1 | 2 | 9.00 | 0.01 | 0 | 110 | 0 | 0 | |
| Test 6 | 1.00 | 0.10 | 1.00 | 9.00 | 0.01 | 1300 | 168 | 56 | 8 | 23 |
| Test 7 | 1.00 | 0.10 | 2.00 | 9.00 | 0.01 | 1346 | 158 | 75 | 9 | 18 |
| Test 8 | 1.00 | 0.10 | 4.00 | 9.00 | 0.01 | 1580 | 140 | 39 | 11 | 41 |
| Test 9 | 2.00 | 0.10 | 2.00 | 9.00 | 0.01 | 1871 | 137 | 168 | 14 | 11 |

The examples cited herein illustrate that with a combination of an organic acid or amino acid and an abrasive, with no oxidizing agent, we are able to remove a barrier film comprising tantalum (such as tantalum and tantalum nitride) from a wafer substrate at a high removal rate, with a low copper removal rate and a low dielectric TEOS removal rate.

In a polishing slurry of this invention, a composition may be preferably adjusted to provide a polishing rate for a barrier film containing tantalum of preferably at least 400 Å/min, more preferably at least 1000 Å/min; and to provide a polishing rate for copper of preferably less than 500 Å/min, more preferably less than 200 Å/min. The composition of the polishing slurry of this invention may be adjusted to provide a polishing rate ratio of the tantalum contained barrier film to copper film of preferably 5/1, more preferably 10/1 or more. The composition of the polishing slurry of this invention may be desirably adjusted to provide a higher polishing rate ratio of the tantalum contained barrier film to the interlayer dielectric film (TaN/ dielectric film polishing ratio) in a polishing slurry of this invention; preferably at least 10/1, more preferably at least 20/1. The result for Test 4 in which citric acid was present in the slurry at 4% by weight, the selectivity of barrier TaN to copper was 9.0 while the selectivity of barrier TaN to insulating layer was 24.5. The result for Test 8 in which glutamic acid was present in the slurry at 4% by weight, the selectivity of barrier TaN to copper was 11 while the selectivity of barrier TaN to insulating layer was 41.

## Claims

1. A method for removal of a barrier film on a semiconductor wafer by polishing with a polishing pad and a polishing fluid, the polishing fluid comprising abrasive particles in the range of 0.1% to 5% by weight and an organic acid or a mixture of two or more organic acids in the range of 0.5-10% by weight in an aqueous solution at basic pH **characterised by** no addition of an oxidizing agent.

2. A method as in claim 1, wherein the organic acid is selected from the group consisting of carboxylic acids, hydrocarboxylic acids containing a hydroxyl group, and amino acids.

3. A method as in claim 2, wherein the organic acid is selected from the group consisting of citric acid, maleic acid, formic acid, acetic acid, propionic acid, butyric acid, valeric acid, acrylic acid, lactic acid, succinic acid malic acid, malonic acid, succinic acid, tartaric acid, phthalic acid, fumaric acid, lactic acid (alpha-hydroxypropionic acid or beta-hydroxypropionic acid), pimelic acid, adipic acid, glutaric acid, oxalic acid, salicylic acid, glycolic acid, tricarballylic acid, and benzoic acid.

4. A method as in claim 2, wherein the amino acid is selected from the group consisting of glutamic acid, glutamic acid hydrochloride, sodium glutaminate monohydrate, glutamine, glutathione, glycylglycine, alanine, beta-alanine, gamma-aminobutyric acid, epsilon-aminocarproic acid, lysine, lysine hydrochloride, lysine dihydrochloride, lysine picrate, histidine, histidine hydrochloride, histidine dihydrochloride, aspartic acid, aspartic acid monohydrate, potassium aspartate, potassium aspartate trihydrate, tryptophan, threonine, glycine, cystine, cysteine, cysteine hydrochloride monohydrate, oxyproline, isoleucine, leucine, methionine, ornithine hydrochloride, phenylalanine, phenylglycine, proline, serine, tyrosine, valine, and a mixture of these amino acids.

5. A method as in claim 1, wherein the said abrasive is silicon dioxide.

6. A method as in claim 3, wherein the organic acid is citric acid.

7. A method as in claim 4, wherein the amino acid is glutamic acid.

8. A method as in claim 1 wherein a metal corrosion inhibitor is added to said polishing solution.

9. A method as in claim 1 wherein the fluid pH is in the range from pH 7 to pH 11.

## Patentansprüche

1. Verfahren zum Entfernen einer Sperrfolie auf einem Halbleiterwafer durch Polieren mit einem Polierpad und einem Polierfluid, wobei das Polierfluid Schleifmittelteilchen im Bereich von 0,1 bis 5 Gewichtsprozent und eine organische Säure oder ein Gemisch von zwei oder mehr organischen Säuren im Bereich von 0,5 bis 10 Gewichtsprozent in einer wässrigen Lösung bei basischem pH umfasst, **gekennzeichnet durch** keine Zugabe eines Oxidationsmittels.

2. Verfahren nach Anspruch 1, wobei die organische Säure aus der Gruppe, bestehend aus Carbonsäuren, Hydrocarbonsäuren, die eine Hydroxylgruppe enthalten, und Aminosäuren, ausgewählt ist.

3. Verfahren nach Anspruch 2, wobei die organische Säure aus der Gruppe, bestehend aus Zitronensäure, Maleinsäure, Ameisensäure, Essigsäure, Propionsäure, Buttersäure, Valeriansäure, Acrylsäure, Milchsäure, Bernsteinsäure, Apfelsäure, Malonsäure, Weinsäure, Phthalsäure, Fumarsäure, Milchsäure (alpha-Hydroxypropionsäure oder beta-Hydroxypropionsäure), Pimelinsäure, Adipinsäure, Glutarsäure, Oxalsäure, Salicylsäure, Glykolsäure, Tricarballylsäure und Benzoesäure, ausgewählt ist.

4. Verfahren nach Anspruch 2, wobei die Aminosäure aus der Gruppe, bestehend aus Glutaminsäure, Glutaminsäurehydrochlorid, Natriumglutaminatmonohydrat, Glutamin, Glutathion, Glycylglycin, Alanin, beta-Alanin, gamma-Aminobuttersäure, epsilon-Aminocapronsäure, Lysin, Lysinhydrochlorid, Lysindihydrochlorid, Lysinpikrat, Histidin, Histidinhydrochlorid, Histidindihydrochlorid, Asparaginsäure, Asparaginsäuremonohydrat, Kaliumaspartat, Kaliumaspartattrihydrat, Tryptophan, Threonin, Glycin, Cystin, Cystein, Cysteinhydrochloridmonohydrat, Oxyprolin, Isoleucin, Leucin, Methionin, Ornithinhydrochlorid, Phenylalanin, Phenylglycin, Prolin, Serin, Tyrosin, Valin und einem Gemisch dieser Aminosäuren, ausgewählt ist.

5. Verfahren nach Anspruch 1, wobei das Schleifmittel Siliziumdioxid ist.

6. Verfahren nach Anspruch 3, wobei die organische Säure Zitronensäure ist.

7. Verfahren nach Anspruch 4, wobei die Aminosäure Glutaminsäure ist.

8. Verfahren nach Anspruch 1, wobei ein Metallkorrosionshemmer zu der Polierlösung gegeben wird.

9. Verfahren nach Anspruch 1, wobei der pH des Fluids im Bereich von pH 7 bis pH 11 liegt.

## Revendications

1. Procédé d'élimination d'une couche barrière sur une tranche semi-conductrice par polissage avec un tampon de polissage et un fluide de polissage, le fluide de polissage comprenant des particules abrasives dans la gamme de 0,1 % à 5 % en poids et un acide organique ou un mélange de deux ou plus de deux acides organiques dans la gamme de 0,5 à 10 % en poids dans une solution aqueuse à un pH basique **caractérisé par** aucune addition d'agent oxydant.

2. Procédé selon la revendication 1, dans lequel l'acide organique est choisi dans le groupe constitué par les acides carboxyliques, les acides hydrocarboxyliques contenant un groupe hydroxyle, et les acides aminés.

3. Procédé selon la revendication 2, dans lequel l'acide organique est choisi dans le groupe constitué par l'acide citrique, l'acide maléique, l'acide formique, l'acide acétique, l'acide propionique, l'acide butyrique, l'acide valérique, l'acide acrylique, l'acide lactique, l'acide succinique, l'acide malique, l'acide malonique, l'acide succinique, l'acide tartrique, l'acide phtalique, l'acide fumarique, l'acide lactique (acide alpha-hydroxypropionique ou acide bêta-hydroxypropionique), l'acide pimélique, l'acide adipique, l'acide glutarique, l'acide oxalique, l'acide salicylique, l'acide glycolique, l'acide tricarballylique et l'acide benzoïque.

4. Procédé selon la revendication 2, dans lequel l'acide aminé est choisi dans le groupe constitué par l'acide glutamique, le chlorhydrate d'acide glutamique, le monohydrate de glutaminate de sodium, la glutamine, la glutathione, la glycylglycine, l'alanine, la bêta-alanine, l'acide gamma-aminobutyrique, l'acide epsilon-aminocarproïque, la lysine, le chlorhydrate de lysine, le dichlorhydrate de lysine, le picrate de lysine, l'histidine, le chlorhydrate d'histidine, le dichlorhydrate d'histidine, l'acide aspartique, le monohydrate d'acide aspartique, l'aspartate de potassium, le trihydrate d'aspartate de potassium, le tryptophane, la thréonine, la glycine, la cystine, la cystéine, le monohydrate de chlorhydrate de cystéine, l'oxyproline, l'isoleucine, la leucine, la méthionine, le chlorhydrate d'ornithine, la phénylalanine, la phénylglycine, la proline, la sérine, la tyrosine, la valine et un mélange de ces acides aminés.

5. Procédé selon la revendication 1, dans lequel ledit abrasif est du dioxyde de silicium.

6. Procédé selon la revendication 3, dans lequel l'acide organique est l'acide citrique.

7. Procédé selon la revendication 4, dans lequel l'acide aminé est l'acide glutamique.

8. Procédé selon la revendication 1, dans lequel un inhibiteur de corrosion de métal est ajouté à ladite solution de polissage.

9. Procédé selon la revendication 1, dans lequel le pH du fluide est dans la gamme de pH 7àpH 11.
